# EUROPEAN PATENT SPECIFICATION

(11) **EP 4 080 551 B1**
(45) Date of publication and mention of the grant of the patent: **09.07.2025**
(21) Application number: 21169660.4
(22) Date of filing: 21.04.2021
(51) Int. Cl.: H01L 23/31, H01L 21/56

(54) **SEMICONDUCTOR POWER MODULE AND METHOD FOR MANUFACTURING A SEMICONDUCTOR POWER MODULE AND SEMICONDUCTOR POWER DEVICE**
LEISTUNGSHALBLEITERMODUL UND VERFAHREN ZUR HERSTELLUNG EINES LEISTUNGSHALBLEITERMODULS UND LEISTUNGSHALBLEITERBAUELEMENT
MODULE DE PUISSANCE À SEMI-CONDUCTEUR ET PROCÉDÉ DE FABRICATION D'UN MODULE DE PUISSANCE À SEMI-CONDUCTEUR ET DISPOSITIF DE PUISSANCE À SEMI-CONDUCTEUR

(43) Date of publication of application: 26.10.2022
(73) Proprietor: Hitachi Energy Ltd, 8050 Zürich (CH)
(72) Inventor: GUILLON, David, 8857 Vorderthal (CH); MOHN, Fabian, 5408 Ennetbaden (CH)
(74) Representative: Epping - Hermann - Fischer

(56) References cited:
- US-A1- 2013 010 440
- US-A1- 2019 157 190

## Description

The present disclosure is related to a semiconductor power module and a method for manufacturing a semiconductor power module for a semiconductor device. The present disclosure is further related to a corresponding semiconductor device.

Document US 2013/010440 A1 discloses a power module invented for easy manufacturing and fatigue reduction at a soldered portion, and a method for manufacturing the same. The power module comprises a substrate where electronic parts are mounted by soldering, and a mold case housing the substrate and including bus bars for electrical connection with an external apparatus.

Document US 2019/157190 A1 discloses a semiconductor device package including a lead frame, a first encapsulated power semiconductor device mounted on a first part of the lead frame and a second encapsulated power semiconductor device mounted on a second part of the lead frame.

A commonly used technology for the encapsulation of small integrated circuits used for low voltage applications is transfer molding, where chips are joined to a leadframe or substrate and encapsulated in a package body. Thereby, a well-suited mold compound must be chosen to fulfil given requirements, which may contradict to each other. In this respect, it is a challenge to provide a mechanically stable power package with reliable functionality.

Embodiments of the disclosure relate to a mechanically stable semiconductor power module with reliable functioning that contributes to an enhanced module life. Embodiments of the disclosure also relate to a corresponding semiconductor device and a manufacturing method for such a semiconductor power module.

These objects are achieved by the subject-matter of the independent claims. Further developments and embodiments are described in the corresponding dependent claims.

According to an embodiment, a semiconductor power module for a semiconductor device comprises a leadframe or substrate and a resin body coupled to the leadframe or substrate. The resin body comprises at least a first resin element and a second resin element, wherein a resin material of the first resin element is different from a resin material of the second resin element. The first and second resin elements are arranged laterally adjacent to each other with respect to a lateral direction of the semiconductor power module. Moreover, the first resin element and the second resin element are separated in part at least with respect to surface areas facing each other by means of a recess. Such a recess can be formed as a penetrating gap between the resin elements such that the entire surface areas facing each other are separated from each other. Alternatively, the recess can be formed as a groove such that a predetermined portion of the surface areas facing each other are separated from each other. The gap and/or the groove can have a width of 0.5 mm or more with respect to a lateral direction of the semiconductor power module. The recess in form of a groove is mechanically formed by means of at least one of cutting, sawing or milling, or thermally formed by means of laser cutting, or chemically formed by means of etching.

By use of the described structure a semiconductor power module is feasible that enables reliable functioning and an enhanced module life even for use in high voltage power module applications, for example for a voltage of at least **0.5** kV, for example. The specifically introduced one or more recesses form stress relief structures between several parts of different resin materials of a resin sealed semiconductor power package.

The leadframe or substrate is configured to realize a solderable metal structure inside a chip package that carry signals from the die to the outside, for example. It can also serve as mechanical support for a given arrangement of chips, integrated circuits and/or other discrete devices. The resin elements are formed on an upper surface of the leadframe or substrate with respect to a stacking direction perpendicular to the lateral directions which span the main plane of extent of the semiconductor power module.

According to an embodiment of the semiconductor power module at least one of the resin material of the first resin element or the second resin element comprises a thermosetting resin. Alternatively or additionally, at least one of the resin material of the first resin element or the second resin element comprises a potting resin.

The resin elements can realize a respective encapsulation and the described semiconductor power module may be manufactured using a frame mounted to a baseplate, wherein the structure according to the resin body are filled with dielectric gel or potting resin, for example, to form the first and/or the second resin elements. The described semiconductor power module is applicable to be used for automotive applications, for example, and can comprise one or more of the following:
- Large package or resin bodies of up to 80 mm side length and more than 10 mm body thickness
- Power terminals made of thick copper
- Encapsulation of insulating substrates and heatsinks having a backside typically exposed from package body
- High electric current and voltage (partly higher than 1 kV)
- Leak-tight mounting to cooler for liquid cooling
- Harsh environmental conditions e.g. in automotive applications.

According to a further embodiment the semiconductor power module comprises at least one of a filling or a coating inside at least one of the recess to fill the penetrating gap or the groove or to cover a surface area of the first and/or the second resin element which limits the gap or the groove. Such a filling or coating can comprise an elastic and/or protective material, e.g. a water repellent material, to improve a tightness of the resin body and the semiconductor power module against humidity or hazardous gases.

The resin body of the described semiconductor power module can further comprise a third resin element with a resin material that is different from the resin material of at least one of the first resin element or the second resin element and wherein the first, the second and the third resin elements all are separated in part at least with respect to surface areas facing each other by means of a recess, respectively.

It is a recognition in connection with the present disclosure that conventional power packages usually feature an encapsulation prepared by transfer molding of a homogeneous mold body made from one single mold compound. In view of a relatively large size of a transfer molded power package it might be difficult to address different local requirements for the best behaviour of the encapsulation material. Thus, some regions of the power package like the vicinity of chips or terminals are clearly more critical with respect to specific requirements like mechanical and thermo-mechanical behaviour or dielectric strength of the encapsulation material than other package parts.

According to the described semiconductor power module in order to improve the mechanical behaviour the encapsulation realized by the resin body is made by the use of two or more mold compounds or other resin materials like potting resin with different material properties for the encapsulation. Several types of resin material can be chosen with respect to specific local requirements according to the predetermined formation of the first, second and/or third resin element.

It is a further recognition in connection with the present disclosure that the implementation of several resin materials in one large package body may cause additional issues. When preparing a large package body from two or more different mold compounds or resin materials by transfer molding or other processes like potting, the sections of these different materials will adhere together, for example. Especially, if several parts of different resin or mold materials are arranged in lateral direction and adhere to each other, strong mechanical or thermo-mechanical stress will be present in the sealed resin body. Such a stress especially occurs on the interfaces of the different material sections and may result in a strong bow of the package body or may even provide mechanical damage to the encapsulation, e.g. voids or cracks, or even cause damages of the package interior after the manufacturing process.

By use of the described structure of the semiconductor power module and the intentionally introduced recesses it is possible to prevent or at counteract these adverse effects, at least. The formed recess between two adjacent resin elements enables to suppress or at least to reduce the stress occurring in a large resin sealed package body consisting of several materials, for example. Additionally, the thermo-mechanical behaviour of the resin body and the semiconductor power module as a whole can be improved in view of its module operation, e.g. during thermal cycling.

According to an embodiment, a semiconductor device, comprises an embodiment of the described semiconductor power module which further includes one or more terminal connections coupled to the leadframe or substrate, and electronics which is coupled with at least one of the terminal connections.

The semiconductor power device can further comprise a heat sink which is coupled with the leadframe or substrate to dissipate heat during operation. Moreover, the semiconductor power device can comprise two or more embodiments of the aforementioned semiconductor power module. The electronics may include chips, integrated circuits and/or other discrete devices.

According to an embodiment, a method for manufacturing an embodiment of the described semiconductor power module comprises providing a leadframe or substrate, and forming a resin body coupled to the leadframe or substrate, wherein the resin body includes at least a first resin element and a second resin element and a resin material of the first resin element is different from a resin material of the second resin element. The first resin element and the second resin element are formed such that they are separated in part at least with respect to surface areas facing each other by means of a recess.

The forming the resin body can comprise providing a substance in terms of a mold compound resin, and applying the provided substance on the leadframe or substrate and thereby forming at least one of the first resin element or the second resin element by means of molding. The molding process can include transfer molding, injection molding and/or compression molding.

Alternatively, the forming the resin body can comprise providing a substance in terms of a potting resin, and applying the provided substance on the leadframe or substrate and thereby forming the first resin element and/or the second resin element by means of potting. Alternatively, one or more resin elements can be formed by means of potting and the other one or more resin elements can be formed by means of molding.

The recess between two resin elements can be formed in terms of a predetermined spacing between these elements or their interface areas. Thus, a recess formed as a penetrating gap or as a partial groove can be given due to a specific manufacturing tool during molding or potting the resin elements, although this example would not fall within the scope of the claimed invention.

The forming of the resin body comprises subsequent formation of the at least one recess. Thus, forming the recess in terms of a penetrating gap or a groove is done mechanically by means of at least one of cutting, sawing and/or milling subsequent to the forming of the first resin element and the second resin element. Alternatively, forming the recess is done thermally by means of laser cutting. Alternatively, forming the recess is done thermally by means of laser cutting. Alternatively, forming the recess is done chemically by means of etching. The aforementioned forming processes comprise the alternative forming of one recess by means of laser cutting and another recess by means of etching.

As a result of that the described semiconductor power device and the described manufacturing method comprise or are related to produce an embodiment of the semiconductor power module, described features and characteristics of the semiconductor power module are also disclosed with respect to the semiconductor power device and the manufacturing method and vice versa.

Exemplary embodiments are explained in the following with the aid of schematic drawings and reference numbers. The figures show:
- Figure 1: an embodiment of a semiconductor power module in a perspective view;
- Figure 2: manufacturing positions of manufacturing an embodiment of the semiconductor power module in a respective side view;
- Figure 3: a further embodiment of the semiconductor power module in a side view; and
- Figure 4: flow chart for a method for manufacturing an embodiment of the semiconductor power module.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in the figures, the description thereof is not repeated for each of the following figures. For the sake of clarity elements might not appear with corresponding reference symbols in all figures possibly.

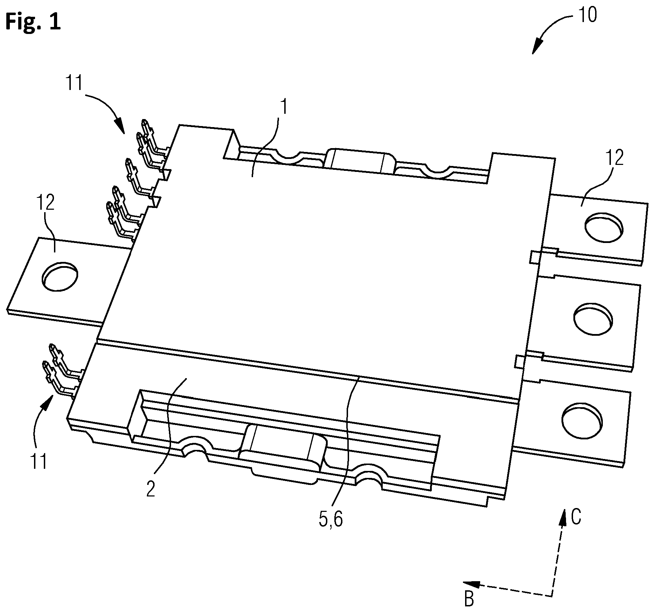

Figure 1 illustrates a perspective view of an embodiment of a semiconductor power module 10 for a semiconductor device. The semiconductor power module 1 comprises a leadframe or substrate 4 and a resin body that is coupled to the leadframe or substrate 4. The resin body forms an enclosure for electronics and includes at least a first resin element 1 and a second resin element 2. A resin material of the first resin element 1 is different from a resin material of the second resin element 2 and the resin elements 1 and 2 are configured such that they are separated in part at least with respect to surface areas facing each other by means of a recess.

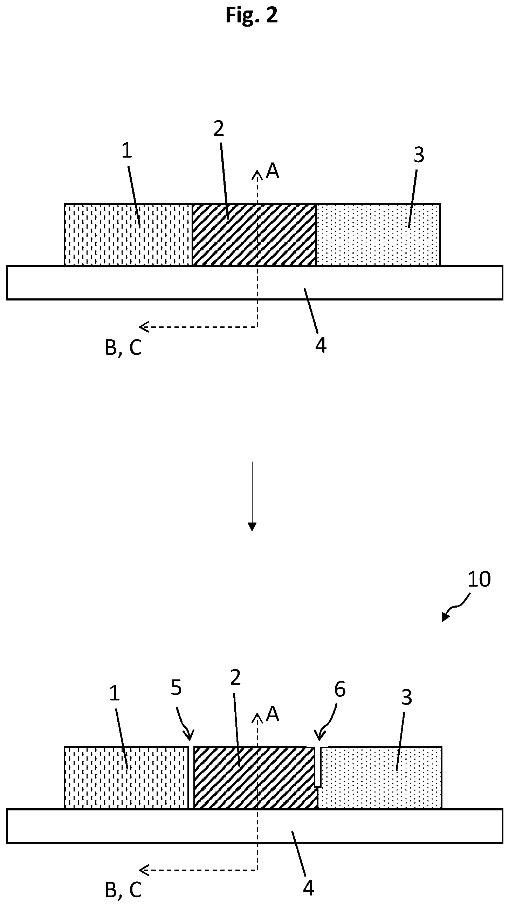

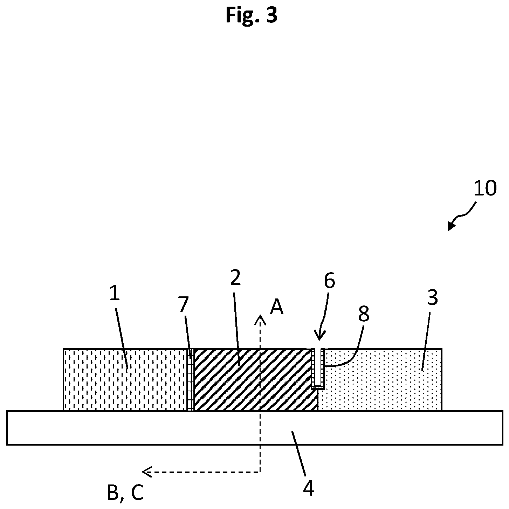

The semiconductor power module 10 further comprises a plurality of first terminal connections 11 and second terminal connections 12 enabling electrical access to the electronics embedded or covered by the resin body. The terminal connections 11 and 12 are coupled to the leadframe or substrate 4. The electronics may include chips, integrated circuits and/or other discrete devices. A main plane of extent of the semiconductor power module 10 is spanned by lateral directions B and C which are orientated perpendicular with respect to each other and with respect to a stacking direction A (see Fig. 2 and 3).

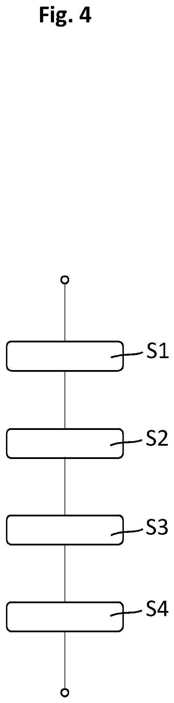

Figure 2 shows in respective side views manufacturing positions for manufacturing an embodiment of the semiconductor power module 10. Steps of a corresponding manufacturing method can follow the flow chart as shown in Figure 4. In a step S1 the leadframe or substrate 4 is provided.

In a step S2 the resin body is formed and coupled to the leadframe or substrate 4. The resin body according to figure 2 includes three resin elements, the first resin element 1, the second resin element 2 and a third resin element 3. All resin elements 1, 2, 3 comprise different resin material. As shown in the upper part of figure 2 the resin elements 1, 2 and 3 are formed adjacent to one another with respect to the lateral direction B, C.

In view of this, it is a recognition of the present disclosure that, if several parts of different resin materials are arranged next to each other they can adhere to each other and cause mechanical or thermo-mechanical stress in the sealed resin body. Such a stress especially occurs on the interfaces or surface areas of the resin elements 1, 2 and 3 facing each other. According to the upper part of figure 2 this would apply the interface between the first and the second resin elements 1 and 2 and between the second and the third resin elements 2 and 3.

In order to prevent a bow of the semiconductor power module 10 or even mechanical damages to the encapsulation of the resin body, e.g. voids or cracks, in a step S3 a respective recess is specifically introduced between the adjacent resin elements 1, 2 and 3 to reduce the contact areas and to form stress relief structures. Such a recess can be formed as a penetrating groove 5, as shown between the first and the second resin elements 1 and 2, or as a groove 6, as shown between the second and the third resin elements 2 and 3 (see the lower part of figure 2, which illustrates the concept of implementation of the penetrating groove 5 and the groove 6 on resin material borders). The penetrating groove 5 extends up to an upper surface of the leadframe or substrate 4 such that the entire surface areas facing each other are separated from each other. The groove 6 is formed such that a predetermined portion of the surface areas facing each other are separated from each other.

Additionally, in a step S4 the penetrating groove 5 can be filled with a given filling 7 and/or the groove 6 can be coated with a given coating 8 to further contribute to reduced mechanical stress and to improved functionality and module life of the semiconductor power module 10 (see figure 3).

The step S2 of forming the resin body can comprise providing a substance in terms of a mold compound resin, and applying the provided substance on the leadframe or substrate 4 and thereby forming one or more of the first resin element 1, the second resin element 2 and the third resin element 3 by means of molding.

Alternatively, the step S2 can comprise providing a substance in terms of a potting resin, and applying the provided substance on the leadframe or substrate 4 and thereby forming one or more of the first resin element 1, the second resin element 2 and the third resin element 3 by means of potting. The step S3 of forming one or more recesses between the resin elements 1, 2 and 3 which falls within the scope of the claimed invention comprises mechanical forming of the penetrating groove 5 and/or the groove 6 by means of cutting, sawing and/or milling. Alternatively or additionally, the step S3 comprises thermal forming of the penetrating groove 5 and/or the groove 6 by means of laser cutting. Alternatively or additionally, the step S3 comprises chemical forming of the penetrating groove 5 and/or the groove 6 by means of etching.

The use of two or more mold compounds or other resin types with different material properties are introduced for the encapsulation of large resin sealed power packages, for example. Consequently, several types of mold compounds or other resin types like potting resin can be chosen with respect to specific local requirements of the resin elements 1, 2 and 3. The manufacturing of a resin sealed semiconductor power module 10 having a resin body made from different mold compounds and/or other resin materials can be done in a sequential manufacturing process of two or more process steps basing transfer molding and/or other encapsulation techniques like potting.

To reduce the mechanical and thermo-mechanical stress occurring to the resin body consisting of several sections of different resin materials, the resin elements 1, 2 and 3 are mechanically, thermally and/or chemically separated from each other in part, at least.

There can be penetrating grooves 5 used as stress relief structures introduced at the interfaces of the different laterally arranged resin elements 1, 2 and 3. These penetrating grooves 5 may be available along a complete border between to two resin elements 1, 2 and 3. Alternatively, the recess can be formed to realize the groove 6 to implement a partly separation between two resin elements 1, 2 and 3. A depth of the penetrating groove 5 implemented for stress relief may have a depth according to the full thickness of the resin body, or a smaller depth may be applied. The implementation may be realized by different possible manufacturing methods.

The different resin elements 1, 2 and 3 are typically laterally arranged on the leadframe or substrate 4.

Alternatively, the resin elements 1, 2 and 3 can be arranged on a substrate, or on a baseplate. The resin elements 1, 2 and 3 may comprise thermosetting resin or potting resin with different material properties, respectively. Consequently, some resin elements 1, 2 and 3 may be prepared by other manufacturing processes instead of transfer molding, for example. So, the second resin element 2 in the centre of the resin body may be prepared from potting resin after preparing the outer first and third resin elements 1 and 3 by transfer molding similar to a dam-and-fill process, for example. However, the single resin elements 1, 2 and 3 comprising different materials are at least partly separated from each other by the intentionally implemented penetrating groove 5 or groove 6. A width of the penetrating groove 5 and/or the groove 6 may be in the range of 0.5 mm or more with respect to the lateral direction B and/or C. Thus, the penetrating groove 5 or the groove 6 can also extend in part along the lateral direction B and in part along the lateral direction C forming an L-shape with respect to a top view along the stacking direction A, for example. To improve a tightness of the resin body and the semiconductor power module 10 against humidity or hazardous gases, the introduced penetrating groove 5 or groove 6 may be filled or coated by an elastic and/or protective material, e.g. water repellent material.

According to an embodiment of the semiconductor power module 10 the resin body and the resin elements 1, 2 and 3 may consist only of different mold compounds or only different potting compounds, or it can be alternatively consist of different material types. Furthermore, resin materials for forming the respective resin element 1, 2 or 3 can be chosen in view of material properties and mechanical properties like adhesion of mold compound and/or filler material. Electrical properties of the resin materials can also be taken into account like filling by varistors, dielectric strength, dielectric constant, or comparative tracking index (CTI value). Alternatively or additionally, the resin material can be chosen in view of protective properties like improved humidity protection or protection against hazardous gases or chemical inertness.

The described structures and embodiments of the resin body enables a preparation of a relative large resin sealed semiconductor power module 10. Basing on the local requirements, the locally optimum resin materials for the planned resin elements 1, 2 and 3 can be chosen. The implementation of the described stress relief structures contributes to a reduced mechanical and thermo-mechanical stress and consequently in a reduced bow of the resin body. Moreover, the semiconductor power module 10 can comprise one or more of the following advantages:
- Improved handling in manufacturing process
- Improved yield in manufacturing process
- Higher module lifetime in operation because of improved reliability with respect to thermal cycles
- Improved thermal interface behaviour due to reduced substrate or baseplate or leadframe bow
- Less issues in implementation of corresponding power packages to customer application, e.g. leak-tight mounting of the semiconductor power module 10 with pin-fin baseplate to cooler for liquid cooling.

The embodiments shown in or described by the figures 1 to 4 as stated represent exemplary embodiments of the improved semiconductor power module 10 and the manufacturing method for; therefore, they do not constitute a complete list of all embodiments. Actual arrangements and methods may vary from the embodiments shown in terms of semiconductor power modules, for example.

### Reference signs

- 1: first resin element
- 2: second resin element
- 3: third resin element
- 4: leadframe / substrate
- 5: penetrating groove
- 6: groove
- 7: filling
- 8: coating
- 10: semiconductor power module
- 11: first terminal connections
- 12: second terminal connections
- A: stacking direction
- B: lateral direction
- C: lateral direction
- S(i): steps of a method for manufacturing a semiconductor power module

## Claims

1. A semiconductor power module (10), comprising:
- a leadframe or substrate (4), and
- a resin body coupled to the leadframe or substrate (4) including at least a first resin element (1) and a second resin element (2), wherein the first and second resin elements (1, 2) are arranged laterally adjacent to each other with respect to a lateral direction (B, C) of the semiconductor power module (10), wherein a resin material of the first resin element (1) is different from a resin material of the second resin element (2) and wherein the first resin element (1) and the second resin element (2) are separated in part at least with respect to surface areas facing each other by means of a recess (5, 6) in form of a groove providing at least a partial space between the first and second resin elements (1, 2), and **characterised in that** the recess (5, 6) in form of a groove is mechanically formed by means of at least one of cutting, sawing or milling, or thermally formed by means of laser cutting, or chemically formed by means of etching.

2. The semiconductor power module (10) according to claim 1, wherein at least one of the resin material of the first resin element (1) or the resin material of the second resin element (2) comprises a thermosetting resin.

3. The semiconductor power module (10) according to claim 1 or 2, wherein at least one of the resin material of the first resin element (1) or the resin material of the second resin element (2) comprises a potting resin.

4. The semiconductor power module (10) according to any one of the preceding claims, wherein the recess is formed as a penetrating groove (5) such that the entire surface areas facing each other are separated from each other.

5. The semiconductor power module (10) according to any one of the preceding claims, wherein at least one of the penetrating groove (5) or the groove (6) has a width of 0.5 mm or more with respect to a lateral direction (B, C) of the semiconductor power module (10).

6. The semiconductor power module (10) according to any one of the claims 4 to 5, comprising at least one of a filling (7) or a coating (8) inside at least one of the penetrating groove (5) or the groove (6).

7. The semiconductor power module (10) according to any one of the preceding claims, wherein the resin body further comprises a third resin element (3) with a resin material that is different from the resin material of at least one of the first resin element (1) or the second resin element (2) and wherein the first resin element (1), the second resin element (2) and the third resin element (3) all are separated in part at least with respect to surface areas facing each other by means of a recess respectively.

8. The semiconductor power module (10) according to any one of the preceding claims further including terminal connections (11, 12) coupled to the leadframe or substrate (4), and
- electronics which is coupled with at least one of the terminal connections (11, 12).

9. A method for manufacturing a semiconductor power module (10), comprising:
- providing a leadframe or substrate (4), and
- forming a resin body coupled to the leadframe or substrate (4), wherein the resin body includes at least a first resin element (1) and a second resin element (2), wherein the first and second resin elements (1, 2) are arranged laterally adjacent to each other with respect to a lateral direction (B, C) of the semiconductor power module (10) and wherein a resin material of the first resin element (1) is different from a resin material of the second resin element (2), and wherein the first resin element (1) and the second resin element (2) are separated in part at least with respect to surface areas facing each other by means of a recess (5, 6) in form of a groove providing at least a partial space between the first and second resin elements (1, 2), **characterised in that** forming the resin body comprises:
-- mechanical forming the recess (5, 6) in form of a penetrating groove (5) or a groove (6) by means of at least one of cutting, sawing or milling subsequent to the forming of the first resin element (1) and the second resin element (2), or
-- thermal forming the recess (5, 6) in form of a penetrating groove (5) or a groove (6) by means of laser cutting subsequent to the forming of the first resin element (1) and the second resin element (2), or
-- chemical forming the recess in the form of a penetrating groove (5) or a groove (6) by means of etching subsequent to the forming of the first resin element (1) and the second resin element (2).

10. The method according to claim 9, wherein the step of forming the resin body comprises:
- providing a substance in the form of a mold compound resin, and
- applying the provided substance on the leadframe or substrate (4) and thereby forming the first resin element (1) and/or the second resin element (2) by means of transfer molding, injections molding and/or compression molding.

11. The method according to claim 9 or 10, wherein the forming the resin body comprises:
- providing a substance in the form of a potting resin, and
- applying the provided substance on the leadframe or substrate (4) and thereby forming at least one of the first resin element (1) or the second resin element (2) by means of potting.

## Patentansprüche

1. Halbleiterleistungsmodul (10), umfassend:
- einen Leiterrahmen oder ein Substrat (4), und
- einen mit dem Leiterrahmen oder Substrat (4) gekoppelten Harzkörper, der mindestens ein erstes Harzelement (1) und ein zweites Harzelement (2) umfasst, wobei das erste und das zweite Harzelement (1, 2) in Bezug auf eine laterale Richtung (B, C) des Halbleiterleistungsmoduls (10) lateral aneinander angrenzend angeordnet sind, wobei sich ein Harzmaterial des ersten Harzelements (1) von einem Harzmaterial des zweiten Harzelements (2) unterscheidet und wobei das erste Harzelement (1) und das zweite Harzelement (2) zumindest teilweise in Bezug auf einander zugewandte Oberflächenbereiche mittels einer Vertiefung (5, 6) in Form einer Nut getrennt sind, die zumindest einen teilweisen Raum zwischen dem ersten und dem zweiten Harzelement (1, 2) bereitstellt, und **dadurch gekennzeichnet, dass** die Vertiefung (5, 6) in Form einer Nut mechanisch mittels mindestens einem von Schneiden, Sägen oder Fräsen gebildet oder thermisch mittels Laserschneiden gebildet oder chemisch mittels Ätzen gebildet ist.

2. Halbleiterleistungsmodul (10) nach Anspruch 1, wobei mindestens eines des Harzmaterials des ersten Harzelements (1) oder des Harzmaterials des zweiten Harzelements (2) ein duroplastisches Harz umfasst.

3. Halbleiterleistungsmodul (10) nach Anspruch 1 oder 2, wobei mindestens eines des Harzmaterials des ersten Harzelements (1) oder des Harzmaterials des zweiten Harzelements (2) ein Vergussharz umfasst.

4. Halbleiterleistungsmodul (10) nach einem der vorhergehenden Ansprüche, wobei die Vertiefung als eine durchdringende Nut (5) ausgebildet ist, so dass die gesamten einander zugewandten Oberflächenbereiche voneinander getrennt sind.

5. Halbleiterleistungsmodul (10) nach einem der vorhergehenden Ansprüche, wobei mindestens eine der durchdringenden Nut (5) oder der Nut (6) eine Breite von 0,5 mm oder mehr in Bezug auf eine laterale Richtung (B, C) des Halbleiterleistungsmoduls (10) aufweist.

6. Halbleiterleistungsmodul (10) nach einem der Ansprüche 4 bis 5, umfassend mindestens eines einer Füllung (7) oder einer Beschichtung (8) innerhalb mindestens einer der durchdringenden Nut (5) oder der Nut (6).

7. Halbleiterleistungsmodul (10) nach einem der vorhergehenden Ansprüche, wobei der Harzkörper ferner ein drittes Harzelement (3) mit einem Harzmaterial umfasst, das sich von dem Harzmaterial mindestens eines des ersten Harzelements (1) oder des zweiten Harzelements (2) unterscheidet, und wobei das erste Harzelement (1), das zweite Harzelement (2) und das dritte Harzelement (3) alle zumindest teilweise in Bezug auf einander zugewandte Oberflächenbereiche mittels jeweils einer Vertiefung getrennt sind.

8. Halbleiterleistungsmodul (10) nach einem der vorhergehenden Ansprüche, ferner umfassend Anschlussverbindungen (11, 12), die mit dem Leiterrahmen oder dem Substrat (4) gekoppelt sind, und
- Elektronik, die mit mindestens einer der Anschlussverbindungen (11, 12) gekoppelt ist.

9. Verfahren zum Herstellen eines Leistungshalbleitermoduls (10), umfassend:
- Bereitstellen eines Leiterrahmens oder Substrats (4), und
- Bilden eines mit dem Leiterrahmen oder Substrat (4) gekoppelten Harzkörpers, wobei der Harzkörper mindestens ein erstes Harzelement (1) und ein zweites Harzelement (2) umfasst, wobei das erste und das zweite Harzelement (1, 2) in Bezug auf eine laterale Richtung (B, C) des Halbleiterleistungsmoduls (10) lateral aneinander angrenzend angeordnet sind und wobei sich ein Harzmaterial des ersten Harzelements (1) von einem Harzmaterial des zweiten Harzelements (2) unterscheidet, und wobei das erste Harzelement (1) und das zweite Harzelement (2) zumindest teilweise in Bezug auf einander zugewandte Oberflächenbereiche mittels einer Vertiefung (5, 6) in Form einer Nut getrennt sind, die zumindest einen teilweisen Raum zwischen dem ersten und dem zweiten Harzelement (1, 2) bereitstellt, **dadurch gekennzeichnet, dass** das Bilden des Harzkörpers umfasst:
- - mechanisches Bilden der Vertiefung (5, 6) in Form einer durchdringenden Nut (5) oder einer Nut (6) mittels mindestens einem von Schneiden, Sägen oder Fräsen nach dem Bilden des ersten Harzelements (1) und des zweiten Harzelements (2), oder
-- thermisches Bilden der Vertiefung (5, 6) in Form einer durchdringenden Nut (5) oder einer Nut (6) mittels Laserschneiden nach dem Bilden des ersten Harzelements (1) und des zweiten Harzelements (2), oder
**--** chemisches Bilden der Vertiefung in Form einer durchdringenden Nut (5) oder einer Nut (6) mittels Ätzen nach dem Bilden des ersten Harzelements (1) und des zweiten Harzelements (2).

10. Verfahren nach Anspruch 9, wobei der Schritt des Bildens des Harzkörpers Folgendes umfasst:
- Bereitstellen einer Substanz in Form eines Formmasseharzes, und
- Aufbringen der bereitgestellten Substanz auf den Leiterrahmen oder das Substrat (4) und dadurch Bilden des ersten Harzelements (1) und/oder des zweiten Harzelements (2) mittels Transferpressen, Spritzgießen und/oder Formpressen.

11. Verfahren nach Anspruch 9 oder 10, wobei das Bilden des Harzkörpers Folgendes umfasst:
- Bereitstellung einer Substanz in Form eines Vergussharzes, und
- Aufbringen der bereitgestellten Substanz auf den Leiterrahmen oder das Substrat (4) und dadurch Bilden mindestens eines des ersten Harzelements (1) oder des zweiten Harzelements (2) mittels Vergießen.

## Revendications

1. Module (10) de puissance à semiconducteur, comprenant :
- une grille de connexions ou un substrat (4), et
- un corps en résine couplé à la grille de connexions ou au substrat (4) comprenant au moins un premier élément en résine (1) et un deuxième élément en résine (2), où les premier et deuxième éléments en résine (1, 2) sont disposés latéralement de manière adjacente l'un à l'autre par rapport à une direction latérale (B, C) du module de puissance à semi-conducteur (10), où un matériau de résine du premier élément en résine (1) est différent d'un matériau de résine du deuxième élément en résine (2) et où le premier élément en résine (1) et le deuxième élément en résine (2) sont séparés en partie au moins par rapport aux surfaces se faisant face au moyen d'un évidement (5, 6) sous la forme d'une rainure fournissant au moins un espace partiel entre les premier et deuxième éléments en résine (1, 2), et **caractérisé en ce que** l'évidement (5, 6) en forme de rainure est formé mécaniquement au moyen d'au moins une opération de découpe, de sciage ou de fraisage, ou formé thermiquement au moyen d'une découpe au laser, ou formé chimiquement au moyen d'une attaque chimique.

2. Module de puissance à semi-conducteur (10) selon la revendication 1, dans lequel au moins l'un parmi le matériau de résine du premier élément en résine (1) et le matériau de résine du deuxième élément en résine (2) comprend une résine thermodurcissable.

3. Module de puissance à semi-conducteur (10) selon la revendication 1 ou la revendication 2, dans lequel au moins l'un parmi le matériau de résine du premier élément en résine (1) et le matériau de résine du deuxième élément en résine (2) comprend une résine d'enrobage.

4. Module de puissance à semi-conducteur (10) selon l'une quelconque des revendications précédentes, dans lequel le renfoncement est formé comme une rainure pénétrante (5) de telle sorte que toutes les surfaces se faisant face sont séparées les unes des autres.

5. Module de puissance à semi-conducteur (10) selon l'une quelconque des revendications précédentes, dans lequel au moins l'une de la rainure pénétrante (5) ou de la rainure (6) a une largeur de 0,5 mm, ou plus, par rapport à une direction latérale (B, C) du module de puissance à semi-conducteur (10).

6. Module de puissance à semi-conducteur (10) selon l'une quelconque des revendications 4 et 5, comprenant au moins l'un d'un remplissage (7) ou d'un revêtement (8) à l'intérieur d'au moins l'une de la rainure pénétrante (5) ou de la rainure (6).

7. Module de puissance à semi-conducteur (10) selon l'une quelconque des revendications précédentes, dans lequel le corps en résine comprend en outre un troisième élément en résine (3) avec un matériau de résine qui est différent du matériau de résine d'au moins l'un parmi le premier élément en résine (1) et le deuxième élément en résine (2), et dans lequel le premier élément en résine (1), le deuxième élément en résine (2) et le troisième élément en résine (3) sont tous séparés en partie au moins par rapport aux surfaces se faisant face au moyen d'un évidement respectif.

8. Module de puissance à semi-conducteur (10) selon l'une quelconque des revendications précédentes, comprenant en outre des connexions de borne (11, 12) couplées à la grille de connexions ou au substrat (4), et
- des composants électroniques qui sont couplés à au moins l'une des connexions de borne (11, 12).

9. Procédé de fabrication d'un module de puissance à semi-conducteur (10), comprenant les étapes suivantes :
- fournir une grille de connexions ou un substrat (4), et
- former un corps en résine couplé à la grille de connexions ou au substrat (4), où le corps en résine comprend au moins un premier élément en résine (1) et un deuxième élément en résine (2), où les premier et deuxième éléments en résine (1, 2) sont disposés latéralement de manière adjacente l'un à l'autre par rapport à une direction latérale (B, C) du module de puissance à semi-conducteur (10), et où un matériau de résine du premier élément en résine (1) est différent d'un matériau de résine du deuxième élément en résine (2), et où le premier élément en résine (1) et le deuxième élément en résine (2) sont séparés en partie au moins par rapport aux surfaces se faisant face au moyen d'un évidement (5, 6) sous la forme d'une rainure fournissant au moins un espace partiel entre les premier et deuxième éléments en résine (1, 2), **caractérisé en ce que** la formation du corps en résine comprend :
-- un formage mécanique de l'évidement (5, 6) sous la forme d'une rainure pénétrante (5) ou d'une rainure (6) au moyen d'au moins une opération parmi une découpe, un sciage ou un fraisage après le formage du premier élément en résine (1) et du deuxième élément en résine (2), ou
-- un formage thermique de l'évidement (5, 6) sous la forme d'une rainure pénétrante (5) ou d'une rainure (6) au moyen d'une découpe au laser après la formation du premier élément en résine (1) et du deuxième élément en résine (2), ou
-- un formage chimique de l'évidement sous la forme d'une rainure pénétrante (5) ou d'une rainure (6) par gravure après la formation du premier élément en résine (1) et du deuxième élément en résine (2).

10. Procédé selon la revendication 9, dans lequel l'étape de formation du corps en résine comprend les étapes suivantes :
- fournir une substance sous la forme d'une résine de moulage, et
- appliquer la substance fournie sur la grille de connexions ou le substrat (4) et former ainsi le premier élément en résine (1) et/ou le deuxième élément en résine (2) par moulage par transfert, moulage par injection et/ou moulage par compression.

11. Procédé selon la revendication 9 ou la revendication 10, dans lequel la formation du corps en résine comprend les étapes suivantes :
- fournir une substance sous la forme d'une résine d'enrobage, et
- appliquer la substance fournie sur la grille de connexions ou le substrat (4) et former ainsi au moins l'un du premier élément en résine (1) ou du deuxième élément en résine (2) par enrobage.
